(19) Europäisches Patentamt
European Patent Office
Office européen des brevets

(11) **EP 2 996 158 B1**

(12) **EUROPEAN PATENT SPECIFICATION**

(45) Date of publication and mention
of the grant of the patent:
**30.05.2018 Bulletin 2018/22**

(51) Int Cl.:
***H01L 31/04*** *(2014.01)*     ***H01L 31/042*** *(2014.01)*

(21) Application number: **13878113.3**

(86) International application number:
**PCT/JP2013/072002**

(22) Date of filing: **16.08.2013**

(87) International publication number:
**WO 2014/141498 (18.09.2014 Gazette 2014/38)**

(54) **SOLAR POWER SYSTEM, ABNORMALITY DETERMINATION PROCESSING DEVICE, ABNORMALITY DETERMINATION PROCESSING METHOD, AND PROGRAM**

SOLARENERGIESYSTEM, VERARBEITUNGSVORRICHTUNG ZUR ANOMALIENBESTIMMUNG, VERARBEITUNGSVERFAHREN ZUR ANOMALIENBESTIMMUNG UND PROGRAMM

SYSTÈME DE PRODUCTION D'ÉNERGIE SOLAIRE, DISPOSITIF DE TRAITEMENT DE DÉTERMINATION D'ANOMALIE, PROCÉDÉ DE TRAITEMENT DE DÉTERMINATION D'ANOMALIE, ET PROGRAMME

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **14.03.2013 JP 2013052438**

(43) Date of publication of application:
**16.03.2016 Bulletin 2016/11**

(73) Proprietor: **Omron Corporation
Kyoto-shi, Kyoto 600-8530 (JP)**

(72) Inventors:
• **TSURUTA Kosuke
Kyoto-shi
Kyoto 600-8530 (JP)**

• **NAKAI Takuya
Kyoto-shi
Kyoto 600-8530 (JP)**

(74) Representative: **Kilian Kilian & Partner
Aidenbachstraße 54
81379 München (DE)**

(56) References cited:
**JP-A- 2011 216 811**     **JP-A- 2012 055 090**
**JP-A- 2012 156 343**     **JP-A- 2012 169 447**
**US-A1- 2011 307 199**     **US-A1- 2012 323 507**

**Description**

TECHNICAL FIELD

The present disclosure relates to a solar power generation system, an abnormality determination processing device, an abnormality determination processing method, and a program, and in particular relates to a solar power generation system, an abnormality determination processing device, an abnormality determination processing method, and a program according to which it is possible to construct a generated power estimation model that can more accurately determine the occurrence of an abnormality.

RELATED ART

In recent years, power generation using renewable energy has been gaining attention, and in particular, the number of power suppliers using solar power generation have increased. Also, in order to perform stable power generation using a solar power generation system and obtain a planned income by selling power, it is necessary to monitor and maintain the solar power generation system.

For example, power obtained using the solar power generation system changes with the solar radiation intensity, and the user can be made aware of the fact that power generation is being performed normally by checking the solar radiation amount and the generated power amount. Also, for example, if a decrease in generated power with respect to the solar radiation amount is confirmed, the cause needs to be specified and countermeasures need to be taken.

For example, the solar radiation amount obtained by measuring the solar radiation intensity and the generated power amount obtained by measuring the generated power are accumulated, and the solar radiation amount and generated power amount obtained during a predetermined period are used to construct a generated power estimation model that estimates an expected power generation amount. Then, if, based on the generated power estimation model, the actual generated power amount is less than the expected power generation amount, which is estimated from the solar radiation amount of a predetermined day and is expected to be generated, and a generation loss occurs, for example, it can be determined that an abnormality has occurred.

For example, Patent Document 1 discloses an abnormality diagnostics apparatus that uses the actual output power and an output characteristic model to estimate a sunlight state value that is the closest in value to the actual output power for each power generation module as a sunlight state estimation value, and determines the occurrence of an abnormality based on the sunlight state estimation value.

RELATED ART DOCUMENTS

PATENT DOCUMENTS

Patent Document 1: JP 2011-181614A
A solar power generation system according to the preamble of claim 1 is known from US 2012/323507 A1. Further prior art is known from US 2011/307199 A1.

SUMMARY OF THE INVENTION

PROBLEM TO BE SOLVED BY THE INVENTION

Incidentally, the generated power amount of the solar power generation system is significantly influenced by variation in solar radiation that occurs due to the season, weather, and the like, and therefore in the case of determining the occurrence of an abnormality using the above-described generated power estimation model, a power generation loss is sometimes detected even if no abnormality has occurred in the device. For this reason, in some cases, it is determined that an abnormality has occurred even if no abnormality has occurred in the device, or it is determined that no abnormality has occurred even though an abnormality has occurred in the device, and thus it is necessary to more accurately detect the occurrence of an abnormality.

The present disclosure has been made in view of such circumstances, and it is an object thereof to be able to construct a generated power estimation model according to which is it possible to more accurately determine the occurrence of an abnormality.

MEANS FOR SOLVING THE PROBLEMS

The above object is achieved by a solar power generation system according to claim 1 and an abnormality determination processing method according to claim 4. Preferred embodiments are subject-matter of the dependent claims.

A solar power generation system according to an aspect of the present disclosure includes: a solar power generation unit configured to generate power by receiving sunlight; a model construction unit configured to construct a generated power estimation model based on a correlative relationship for each day between a generated power amount generated by the solar power generation unit and an energy amount of sunlight emitted to the solar power generation unit, the generated power estimation model being used for estimating an expected generated power amount that is expected to be generated by the solar power generation unit; an estimation unit configured to estimate the expected generated power amount based on the generated power estimation model; and an abnormality determination unit configured to determine whether or not an abnormality has occurred by comparing the expected generated power amount and a generated power amount that is actually generated by the solar power generation unit.

An abnormality determination processing device according to an aspect of the present disclosure includes: a model construction unit configured to construct a generated power estimation model based on a correlative relationship for each day between a generated power amount generated by a solar power generation unit that generates power by receiving sunlight, and an energy amount of sunlight emitted to the solar power generation unit, the generated power estimation model being used for estimating an expected generated power amount that is expected to be generated by the solar power generation unit; an estimation unit configured to estimate the expected generated power amount based on the generated power estimation model; and an abnormality determination unit configured to determine whether or not an abnormality has occurred by comparing the expected generated power amount and a generated power amount that is actually generated by the solar power generation unit.

An abnormality determination processing method and program according to an aspect of the present disclosure include the steps of: constructing a generated power estimation model based on a correlative relationship for each day between a generated power amount generated by a solar power generation unit that generates power by receiving sunlight, and an energy amount of sunlight emitted to the solar power generation unit, the generated power estimation model being used for estimating an expected generated power amount that is expected to be generated by the solar power generation unit; estimating the expected generated power amount based on the generated power estimation model; and determining whether or not an abnormality has occurred by comparing the expected generated power amount and a generated power amount that is actually generated by the solar power generation unit.

In one aspect of the present disclosure, a generated power estimation model to be used for estimating an expected generated power amount that is expected to be generated by the solar power generation unit is constructed based on a correlative relationship for each day between a generated power amount generated by a solar power generation unit that generated power by receiving sunlight, and an energy amount of sunlight emitted to the solar power generation unit, the estimated generated power amount is estimated based on the generated power estimation model, and it is determined whether or not an abnormality has occurred by comparing the expected generated power amount and a generated power amount that is actually generated by the solar power generation unit.

EFFECTS OF THE INVENTION

According to an aspect of the present disclosure, it is possible to construct a generated power estimation model according to which is it possible to more accurately determine the occurrence of an abnormality.

BRIEF DESCRIPTION OF THE DRAWINGS

FIG. 1    is a block diagram showing an example of a configuration of a solar power generation system.
FIG. 2    is a diagram showing an example of solar radiation intensity data and generated power data.
FIG. 3    is a diagram for describing a solar radiation amount, a generated power amount, and an expected generated power amount.
FIG. 4    is a diagram showing an example of a correlative relationship between solar radiation intensity and generated power.
FIG. 5    is a diagram showing the solar radiation intensity, the expected generated power amount, and the generated power.
FIG. 6    is a diagram for describing determination of whether or not an abnormality has occurred.
FIG. 7    is a diagram for describing the influence of intra-day variation in solar radiation.
FIG. 8    is a diagram showing a correlative relationship between the solar radiation intensity and the generated power, which includes noise.
FIG. 9    is a block diagram showing an example of a configuration of a first embodiment of a solar power generation system to which the present technique has been applied.

FIG. 10    is a block diagram showing an example of a configuration of an abnormality determination processing device.

FIG. 11    is a diagram for describing processing performed by a solar radiation variation determination unit.

FIG. 12    is a diagram showing an improved correlative relationship between the solar radiation intensity and the generated power.

FIG. 13    is a flowchart for describing processing performed by the abnormality determination processing device.

FIG. 14    is a block diagram showing an example of a configuration of a first embodiment of a computer to which the present techniques have been applied.

EMBODIMENTS OF THE INVENTION

Hereinafter, a specific embodiment to which the present technique has been applied will be described in detail with reference to the drawings.

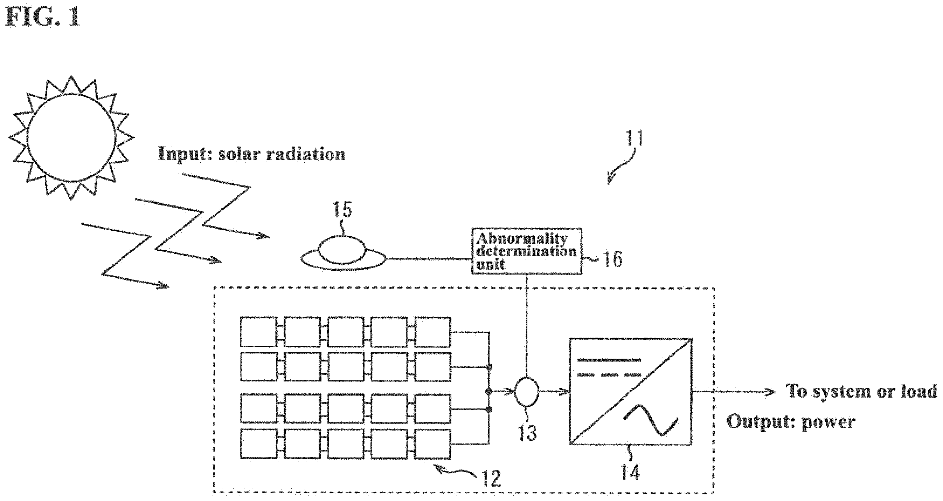

First, with reference given to FIGS. 1 to 8, the overall configuration of a solar power generation system and abnormality determination based on the generated power estimation model for estimating an expected power generation amount will be described.

FIG. 1 is a block diagram showing an example of a configuration of a solar power generation system.

As shown in FIG. 1, a solar power generation system 11 is configured to include a solar power generation module 12, a power measurement unit 13, an inverter 14, a solar radiation meter 15, and an abnormality determination unit 16. Also, the solar power generation system 11 uses solar radiation (solar energy) from the sun as input, converts the solar radiation into power (electrical energy), and outputs the power to a system or a load.

The solar power generation module 12 is constituted by a solar cell array configured by connecting in parallel a string of solar cells, which is obtained by wiring multiple solar cell panels in series, such that a predetermined output is obtained, and the solar power generation module 12 outputs power generated according to the solar radiation intensity.

The power measurement unit 13 is disposed on an electrical wire connecting the solar power generation module 12 and the inverter 14, and measures the generated power generated by the solar power generation module 12.

The inverter 14 performs DC/AC (direct current/alternating current) conversion on the power output from the solar power generation module 12 and outputs it to a system or a load.

The solar radiation meter 15 is disposed near the solar power generation module 12 and measures the solar radiation intensity of sunlight emitted from the sun.

The abnormality determination unit 16 reads out the generated power measured by the power measurement unit 13 each predetermined unit time (e.g., seconds or minutes) and acquires generated power data in which temporal changes in the generated power is recorded. Similarly, each predetermined unit time, the abnormality determination unit 16 reads out the solar radiation intensity measured by the solar radiation meter 15 and acquires the solar radiation intensity data in which temporal changes in the solar radiation intensity are recorded. Based on the fact that the generated power obtained by the solar power generation system 11 changes with the solar radiation intensity, the abnormality determination unit 16 uses the solar radiation intensity data and the generated power data to determine whether or not an abnormality has occurred in the solar power generation system 11.

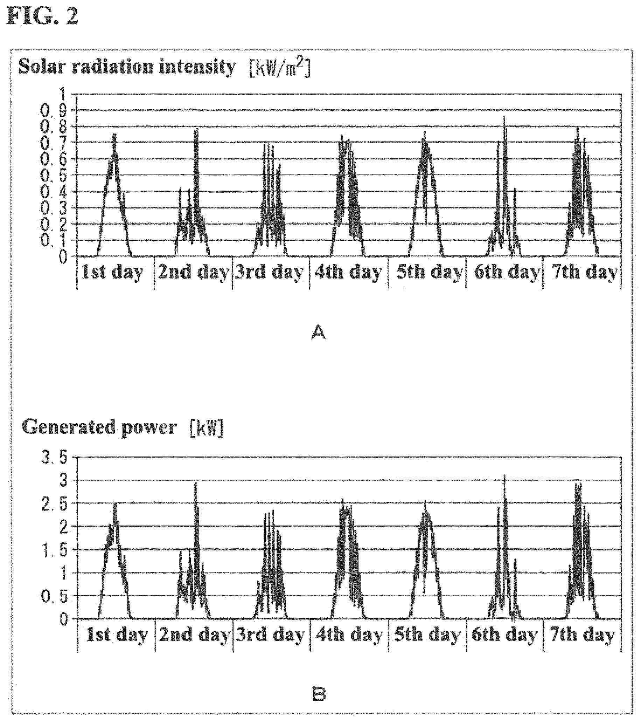

For example, a seven-day (week-long) example is shown in FIG. 2 regarding the solar radiation intensity data and the generated power data acquired by the abnormality determination unit 16.

FIG. 2A shows solar radiation intensity data acquired by the abnormality determination unit 16, in which the vertical axis indicates the solar radiation intensity, and the horizontal axis indicates the measurement date/time. The abnormality determination unit 16 acquires the solar radiation intensity data, which changes as shown in FIG. 2A, from the solar radiation intensity measured by the solar radiation meter 15.

FIG. 2B shows generated power data acquired by the abnormality determination unit 16, in which the vertical axis indicates the generated power, and the horizontal axis indicates the measurement date/time. The abnormality determination unit 16 obtains the generated power data, which changes as shown in FIG. 2B, from the generated power measured by the power measurement unit 13.

Also, the abnormality determination unit 16 calculates the solar radiation amount for each day by integrating the solar radiation intensity of each day, and calculates the generated power amount for each day by integrating the generated power of each day.

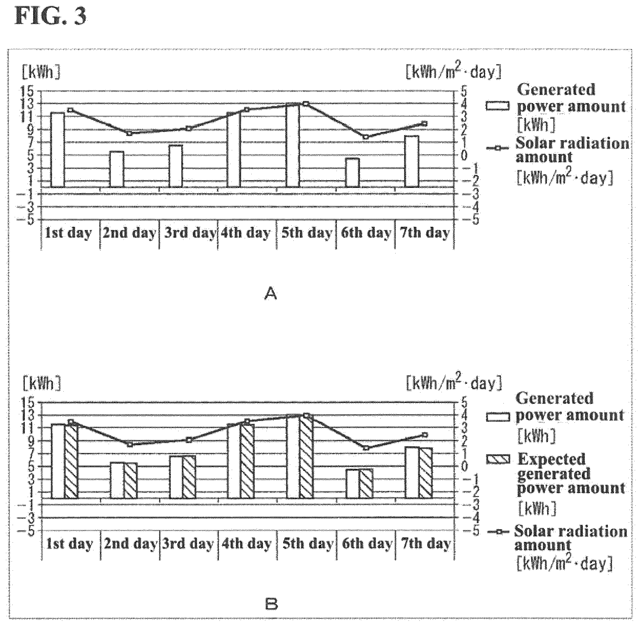

The solar radiation amount and generated power amount calculated by the abnormality determination unit 16, and the expected generated power amount, which is obtained from the solar radiation amount (e.g., the amount of solar energy emitted to the solar power generation module 12) and is expected to be generated by the solar power generation module 12, will be described with reference to FIG. 3.

FIG. 3A shows the solar radiation amount and generated power amount calculated by the abnormality determination unit 16, the left vertical axis indicating the generated power amount, the right vertical axis indicating the solar radiation amount, and the horizontal axis indicating the measurement date. The solar radiation amounts shown in FIG.

3A are values obtained by integrating the solar radiation intensities shown in FIG. 2A for each day, and the generated power amounts are values obtained by integrating the generated power shown in FIG. 2B for each day.

By managing the solar radiation amounts and generated power amounts in this manner, it is possible to qualitatively determine the appropriateness of the generated power amount with respect to the solar radiation amount, such as power generation being favorable since the solar radiation amount is high, or power generation not being favorable since the solar radiation amount is low.

FIG. 3B shows the expected generated power amount, which is expected to be generated, being added to the solar radiation amount and generated power amount shown in FIG. 3A.

As shown in FIG. 3B, if the solar radiation amount is low as with the generated power amounts with respect to the solar radiation amounts on the second day and sixth day, only a low power amount will be generated according to the solar radiation amount, and thereby it is possible to determine that the generated power amount with respect to the solar radiation amount is appropriate. Thus, by using the cumulative data of the solar radiation amount and the generated power amount to estimate the expected generated power amount that is to be a reference for a decrease in generation, it is possible to determine the appropriateness of the generated power amount with respect to the solar radiation amount, or in other words, to determine whether or not power generation is being performed as expected.

The generated power estimation model used in the estimation of this kind of expected generated power amount is constructed based on the high correlation between the solar radiation intensity and the generated power.

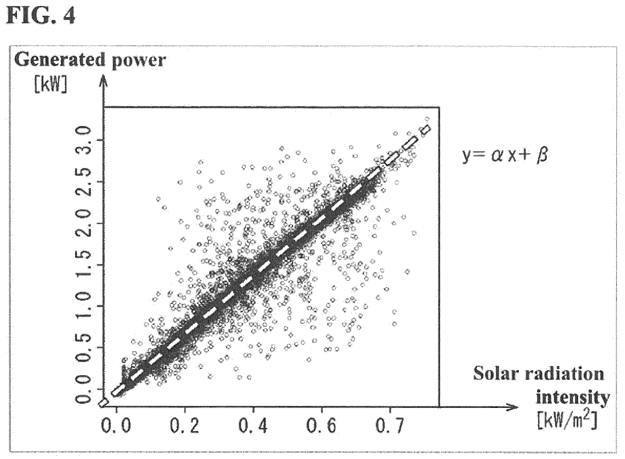

FIG. 4 is a diagram showing an example of a correlative relationship between solar radiation intensity and generated power. In FIG. 4, the vertical axis indicates the generated power and the horizontal axis indicates the solar radiation intensity.

In FIG. 4, for example, the solar radiation intensity and generated power shown in FIG. 2 are plotted. Thus, it is shown that the solar radiation intensity and the generated power have a high correlation, and a function ($y=f(x)$) that estimates the generated power ($y$) from the solar radiation intensity ($x$) is obtained as the generated power estimation model. Specifically, a linear regression equation ($y=\alpha x+\beta$) such as that shown in FIG. 4 is obtained as the generated power estimation model.

Then, using the generated power estimation model obtained in this manner, the abnormality determination unit 16 estimates the expected power generation amount and calculates the difference between the estimated expected generated power amount and the actually-measured generated power amount as the power generation loss. For example, the abnormality determination unit 16 inputs the solar radiation intensity ($x$) on the day before the target day for estimating the expected generated power amount into the generated power estimation model, and calculates the expected generated power ($y'$).

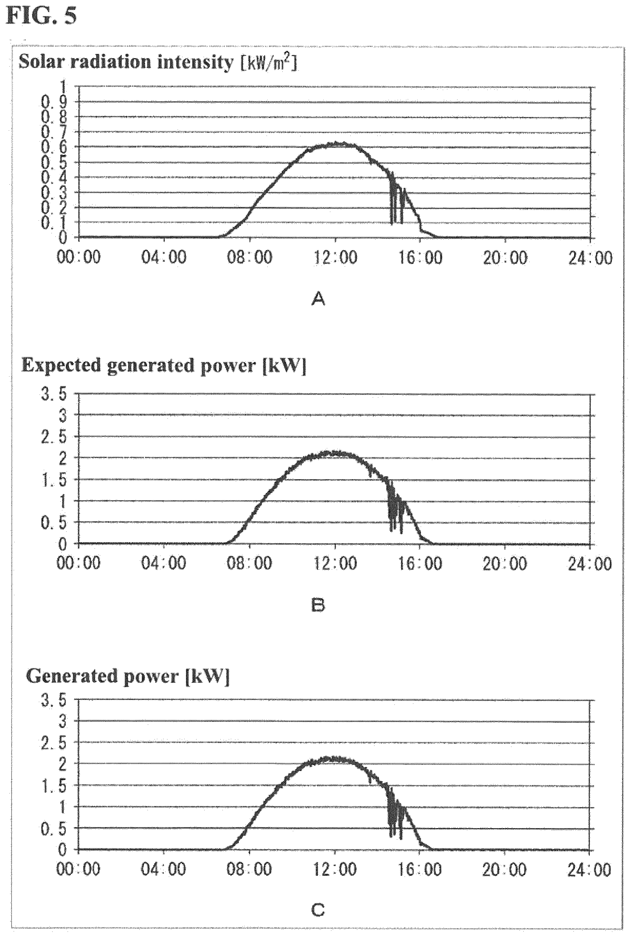

For example, an expected generated power amount such as that shown in FIG. 5B is calculated by inputting a solar radiation intensity such as that shown in FIG. 5A into the generated power estimation model.

Thereafter, as shown in FIG. 5C, when the generated power on the target day is actually measured, the abnormality determination unit 16 calculates the difference between the generated power amount and the expected generated power amount as the power generation loss (= generated power amount - expected generated power amount), and thereby it can be determined whether or not an abnormality has occurred in the solar power generation module 12. For example, if the power generation loss is almost zero (e.g., less than or equal to a predetermined threshold value), the abnormality determination unit 16 can determine that no abnormality has occurred in the solar power generation module 12, or in other words, that the solar power generation module 12 is in a normal state.

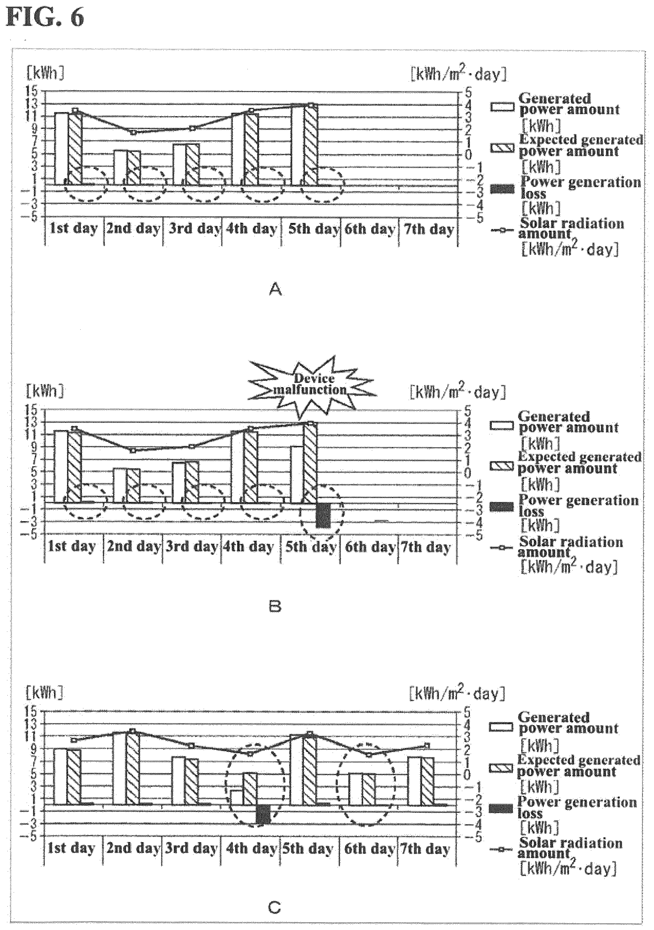

The determination of whether or not an abnormality has occurred in the solar power generation module 12 will be described next with reference to FIG. 6.

FIG. 6 shows an example of cumulative data accumulated by the abnormality determination unit 16. In FIG. 6, the left vertical axis indicates the generated power amount, the expected generated power amount, and the power generation loss, the right vertical axis indicates the solar radiation amount, and the horizontal axis indicates the measurement date.

For example, as shown in FIG. 6A, if the power generation loss is almost zero, the abnormality determination unit 16 determines that the solar power generation module 12 is in the normal state.

On the other hand, if the device including the solar power generation module 12 malfunctions, as shown in FIG. 6B, power generation loss occurs and the abnormality determination unit 16 determines that an abnormality has occurred in the solar power generation module 12. In the example shown in FIG. 6B, it is determined that an abnormality has occurred on the fifth day.

However, regardless of the fact that the device included in the solar power generation module 12 has not malfunctioned, sometimes the expected generated power amount is not obtained, even though the solar radiation amount is sufficient.

That is to say, as shown in FIG. 6C, upon focusing on the sixth day, which is after the fourth day, when the power generation loss was detected, due to the fact that the solar radiation amount of the sixth day is approximately the same as that of the fourth day and no power generation loss occurred on the sixth day, it is determined that the device included in the solar power generation module 12 has not malfunctioned. Conversely, even though the device included in the solar power generation module 12 has not malfunctioned, it can be said that the expected power generation could not be performed on the fourth day regardless of the fact that there was enough solar radiation to be able to generate an amount of power similar to that of the sixth day. Accordingly, it is estimated that the power generation loss that occurred on the fourth day was caused by something other than device malfunction. That is to say, it can be said that the determination that an abnormality occurred based on the power generation loss on the fourth day was a result of erroneous detection.

Thus, regardless of the fact that the device included in the solar power generation module 12 has not malfunctioned, a disparity occurs in the generated amount with approximately the same solar radiation amount because it is estimated that the generated power amount will sometimes be lower with respect to the solar radiation amount of a day due to the influence of intra-day variation in the solar radiation.

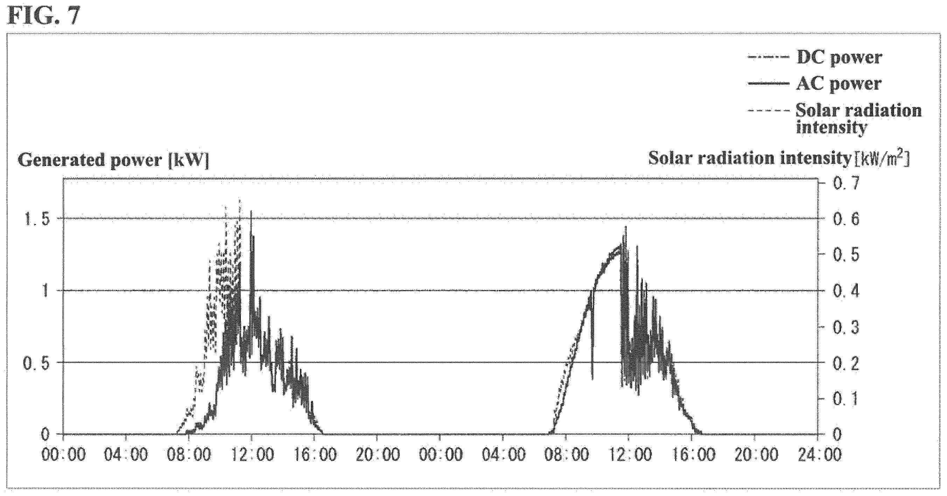

For example, FIG. 7 shows the solar radiation intensity, DC power output from the solar power generation module 12, and AC power output from the inverter 14, all of which have been measured over two days.

For example, FIG. 7 shows that in the morning of the first day, the solar radiation intensity and the DC power and AC power do not coincide with each other, and thereby the power generation does not follow the intra-day variation in the solar radiation. That is to say, the correlation between the solar radiation and the power generation in the morning time slot of the first day is remarkably low. Also, it is shown that the power generation follows the variation in the solar radiation on the second day due to the solar radiation intensity and the DC power and AC power being approximately in conformity with each other. That is to say, the correlation between the solar radiation and the power generation throughout the second day is significantly high.

Thus, upon plotting the solar radiation intensity and generated power whose correlation is remarkably low, as shown in FIG. 4, the accuracy of the generated power estimation model obtained from this kind of correlative relationship decreases.

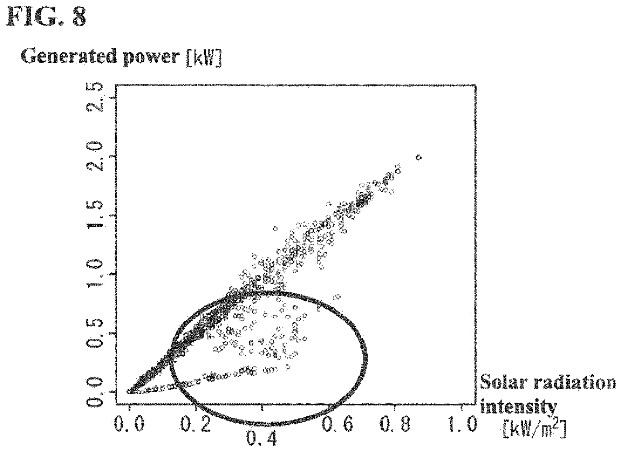

In other words, FIG. 8 shows a plotted correlative relationship between the solar radiation intensity and the generated power, which includes the solar radiation intensity and generated power whose correlation is remarkably low as well.

As shown in FIG. 8, noise appears in the correlative relationship between the solar radiation intensity and the generated power due to a lack of sunlight or intra-day variation in the solar radiation (dramatic change in the weather). In view of this, it is necessary to improve the accuracy of the generated power estimation model by eliminating such noise.

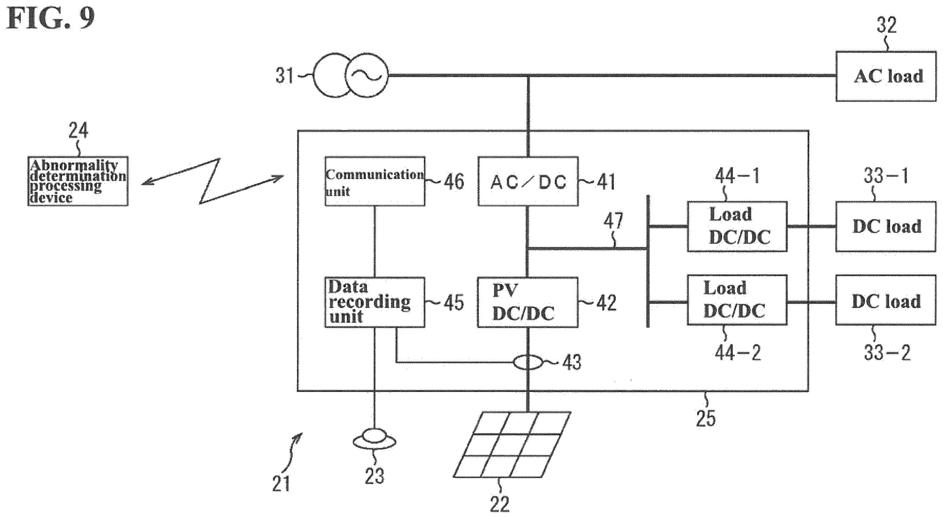

FIG. 9 is a block diagram showing an example of a configuration of an embodiment of a solar power generation system to which the present technique has been applied.

As shown in FIG. 9, the solar power generation system 21 is configured to include a solar power generation module 22, a solar radiation meter 23, an abnormality determination processing device 24, and a power control device 25.

The solar power generation module 22 is constituted by a solar cell array configured by connecting in parallel a string of solar cells, which is obtained by wiring multiple solar cell panels in series, such that a predetermined output is obtained. Also, the solar power generation module 22 performs generates power by receiving sunlight, and supplies the power obtained according to the solar radiation intensity to the power control device 25.

The solar radiation meter 23 is disposed near the solar power generation module 22 and measures the solar radiation intensity of sunlight emitted from the sun.

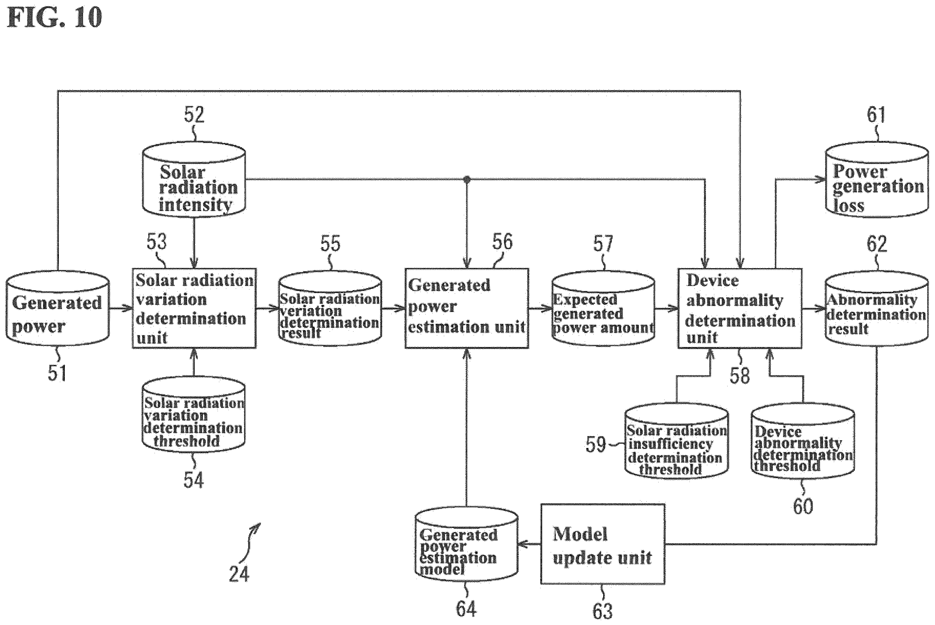

The abnormality detection processing device 24 performs communication with the power control device 25 so as to acquire solar radiation intensity data and generated power data recorded in the power control device 25 and determine whether or not an abnormality has occurred in the solar power generation module 22. Note that the configuration of the abnormality determination processing device 24 will be described in detail later with reference to FIG. 10.

A power system 31, an AC (alternating current) load 32, and DC (direct current) loads 33-1 and 33-2 are connected to the power control device 25. Also, in accordance with the power generated by the solar power generation module 22, the power consumed by the AC load 32 and the DC loads 33-1 and 33-2, the power control device 25 controls the supply of power to the AC load 32 and the DC loads 33-1 and 33-2 and inverse power flow to the power system 31.

Also, the power control device 25 is configured to include an AC/DC conversion unit 41, a PV (photovoltaic) DC/DC conversion unit 42, a power measurement unit 43, load D/C conversion units 44-1 and 44-2, a data recording unit 45, and a communication unit 46. Also, inside of the power control device 25, the AC/DC conversion unit 41, the PV DC/DC conversion unit 42, and the load DC/DC conversion units 44-1 and 44-2 are connected via a DC bus 47.

The AC/DC conversion unit 41 is connected to the power system 31 and the AC load 32, performs AC/DC conversion on the power supplied from the power system 31, and supplies it to the load DC/DC conversion units 44-1 and 44-2 via the DC bus 47. Also, the AC/DC conversion unit 41 performs DC/AC conversion on the power that is generated by the solar power generation module 22 and supplied via the DC bus 47, and supplies the converted power to the AC load 32 or causes it to flow in reverse to the power system 31.

The PV DC/DC conversion unit 42 is connected to the solar power generation module 22, performs DC/DC conversion on the such that the voltage of the power generated by the solar power generation module 22 is converted into a voltage that can be supplied via the DC bus 47, and outputs the voltage from the solar power generation module 22 to the DC bus 47.

The power measurement unit 43 is disposed on an electrical wire connecting the solar power generation module 22 and the PV DC/DC conversion unit 42, and measures the generated power generated by the solar power generation module 22.

The load DC/DC conversion units 44-1 and 44-2 convert the voltage of the power supplied from the AC/DC conversion unit 41 or the PV DC/DC conversion unit 42 via the DC bus 47 into voltages needed for driving the DC loads 33-1 and 33-2 respectively, and output the voltages.

The data recording unit 45 reads out the solar radiation intensity measured by the solar radiation meter 23 for each predetermined unit time (e.g., seconds or minutes) and acquires the solar radiation intensity data in which temporal changes in the solar radiation intensity are recorded. Similarly, the data recording unit 45 reads out the generated power measured by the power measurement unit 43 for each predetermined unit time and acquires generated power data in which temporal changes in the generated power is recorded.

The communication unit 46 performs communication with the abnormality determination processing device 24 using wireless communication and transmits the solar radiation intensity data and generated power data recorded by the data recording unit 45 for each predetermined period (e.g., one hour or one day) to the abnormality determination processing device 24.

Next, FIG. 10 is a block diagram showing an example of a configuration of the abnormality determination processing device 24.

As shown in FIG. 10, the abnormality determination processing device 24 is configured to include a generated power storage unit 51, a solar radiation intensity storage unit 52, a solar radiation variation determination unit 53, a solar radiation variation determination threshold storage unit 54, a solar radiation variation determination result storage unit 55, a generated power estimation unit 56, an expected generated power amount storage unit 57, a device abnormality determination unit 58, a solar radiation insufficiency determination threshold storage unit 59, a device abnormality determination threshold storage unit 60, a power generation loss storage unit 61, an abnormality determination result storage unit 62, a model update unit 63, and a generated power estimation model storage unit 64.

The generated power storage unit 51 stores the generated power data transmitted from the communication unit 46 of the power control device 25 in FIG. 9.

The solar radiation intensity storage unit 52 stores the solar radiation intensity data transmitted from the communication unit 46 of the power control device 25.

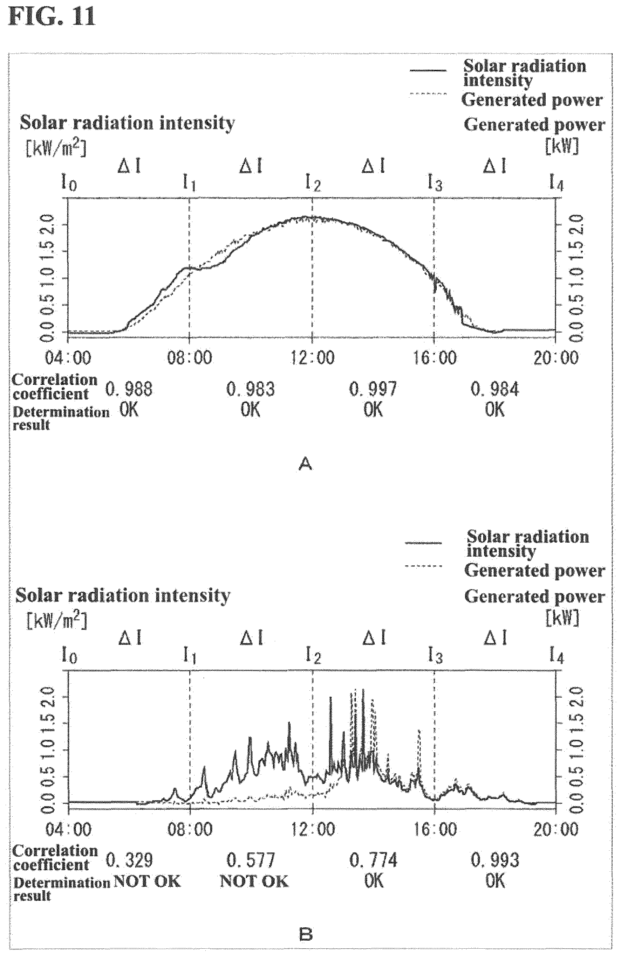

The solar radiation variation determination unit 53 determines whether or not the degree of similarity between the generated power data stored in the generated power storage unit 51 and the solar radiation intensity data stored in the solar radiation intensity storage unit 52 is high for each predetermined local segment. For example, the solar radiation variation determination unit 53 calculates a correlation coefficient for the generated power data and the solar radiation intensity data in a local segment, and if the calculated correlation coefficient is larger than a predetermined solar radiation variation determination threshold, it is determined that the degree of similarity between the generated power data and the solar radiation intensity data in that local segment is high. Note that the processing performed by the solar radiation variation determination unit 53 will be described later with reference to FIG. 11.

The solar radiation variation determination threshold storage unit 54 stores the solar radiation variation determination threshold (e.g., a value such as 0.7) used by the solar radiation variation determination unit 53 for determining the degree of similarity between the generated power data and the solar radiation intensity data.

The solar radiation variation determination result storage unit 55 stores the result of the solar radiation variation determination performed by the solar radiation variation determination unit 53, or in other words, the result (OK/NOT OK) indicating whether or not the degree of similarity between the generated power data and the solar radiation intensity data is high for each local segment.

If the result of the solar radiation variation determination performed by the solar radiation variation determination unit 53 indicates that the degree of similarity between the generated power data and the solar radiation intensity data is high, the generated power estimation unit 56 reads out the solar radiation intensity data for that local segment from the solar radiation intensity storage unit 52. Then, the generated power estimation unit 56 calculates the solar radiation amount by integrating the solar radiation intensity data, and inputs it into the generated power estimation model stored in the generated power estimation model storage unit 64 so as to estimate the expected generated power amount.

The expected generated power amount storage unit 57 stores the expected generated power amount estimated by the generated power estimation unit 56.

The device abnormality determination unit 58 first reads out the solar radiation intensity data from the solar radiation intensity storage unit 52 so as to calculate a solar radiation amount for one day, and determines whether or not the solar radiation is insufficient by comparing the solar radiation amount with a predetermined solar radiation insufficiency determination threshold. Then, if it is determined that the solar radiation is not insufficient, the device abnormality determination unit 58 reads out the generated power data from the generated power storage unit 51 so as to calculate the generated power amount, and calculates the power generation loss by obtaining the difference between the generated power amount and the expected generated power amount stored in the expected generated power amount storage unit 57. The device abnormality determination unit 58 determines whether or not an abnormality has occurred by comparing the power generation loss and the predetermined device abnormality determination threshold. Note that if it is determined that the solar radiation is insufficient, the device abnormality determination unit 58 determines that the determination of whether or not an abnormality has occurred cannot be performed accurately, skips the processing for determining whether or not an abnormality has occurred, and does not determine whether or not an abnormality has occurred.

The solar radiation insufficiency determination threshold storage unit 59 stores the solar radiation determination threshold to be used by the device abnormality determination unit 58 to determine whether or not solar radiation is insufficient.

The device abnormality determination threshold storage unit 60 stores the device abnormality determination threshold to be used by the device abnormality determination unit 58 to determine whether or not an abnormality has occurred.

The power generation loss storage unit 61 stores the power generation loss calculated by the device abnormality determination unit 58.

The abnormality determination result storage unit 62 stores the result of the determination performed by the device abnormality determination unit 58, or in other words, the result indicating whether or not an abnormality has occurred.

The model update unit 63 updates statistical information by adding the solar radiation intensity and generated power for which it has been determined that no abnormality has occurred to the statistical information (correlative relationship between the solar radiation intensity and generated power shown in FIG. 4) used to construct the current generated power estimation model stored in the generated power estimation model storage unit 64. Also, the model update unit 63 constructs a new generated power estimation model using the updated statistical information. That is to say, the model update unit 63 constructs the generated power estimation model based on the correlative relationship between the generated power amount of one day calculated from the generated power for which it is determined that no abnormality has occurred, and the solar radiation amount of one day calculated from the solar radiation intensity for which it is determined that no abnormality has occurred, or in other words, based on the correlative relationship of each day between the generated power amount and the solar radiation amount. Note that the model update unit 63 may construct the generated power estimation model based on the correlative relationship for each local segment.

The generated power estimation model storage unit 64 stores the generated power estimation model newly constructed by the model update unit 63.

Processing according to which the solar radiation variation determination unit 53 determines whether or not the degree of similarity between the generated power data and the solar radiation intensity data is high for each predetermined local segment will be described next with reference to FIG. 11.

FIG. 11 shows solar radiation intensity data and generated power data of a predetermined period (04:00 to 20:00) during which power is generated in a day. The solar radiation variation determination unit 53 calculates a coefficient of correlation between the solar radiation intensity and the generated power for each local segment obtained by dividing one day into multiple local segments, and performs determination for each local segment.

For example, in order to obtain the coefficient of correlation, the solar radiation variation determination unit 53 first uses a sample number i (i=1, 2, ..., I) to define the solar radiation intensity data and the generated power data as solar radiation intensity $x_i$ and generated power yi.

Also, a local segment width $\Delta I$ is obtained by dividing any period I for determining the degree of similarity between the generated power data and the solar radiation intensity data by a division number N. That is to say, the local segment width $\Delta I$ is obtained using the following equation (1).

[Equation 1]

$$\Delta I = \frac{I}{N} \qquad \cdots (1)$$

As shown in FIG. 11, if the division number N is 4, the local segment width $\Delta I$ is obtained using the following equation (2).

[Equation 2]

$$\Delta I = \frac{I}{4} \qquad \cdots (2)$$

Accordingly, letting $I_0 = 0$, a first local segment $I_1$, a second local segment $I_2$, a third local segment $I_3$, and a fourth local segment $I_4$ are obtained using the following equation (3).
[Equation 3]

$$I_1 = \Delta I$$
$$I_2 = I_1 + \Delta I$$
$$I_3 = I_2 + \Delta I \qquad \cdots (3)$$
$$I_4 = I_3 + \Delta I$$

That is to say, the J-th local segment $I_J$ is obtained using the following equation (4).
[Equation 4]

$$I_j = I_{j-1} + \Delta I \qquad \cdots (4)$$

Here, the sampling number i is such that i=1, 2, ..., $I_1$, $I_{1+1}$, ..., $I_2$, ..., $I_3$, ..., $I_4$, and $I_4$=I.

Also, a correlation coefficient $\rho_{xy}$ between the solar radiation intensity x and the generated power y is obtained according to the following equation (5), using an average $\mu_x$ of the solar radiation intensity x, an average $\mu_y$ of the generated power y, a variance (standard deviation) $\sigma_x^2$ of the solar radiation intensity x, and a variance (standard deviation) $\sigma_y^2$ of the generated power y.
[Equation 5]

$$\rho_{xy} = \frac{\sum_{i=1}^{I} (x_i - \mu_x)(y_i - \mu_y)}{\sigma_x \sigma_y}$$

$$\mu_x = \frac{1}{I} \sum_{i=1}^{I} x_i$$

$$\mu_y = \frac{1}{I} \sum_{i=1}^{I} y_i \qquad \cdots (5)$$

$$\sigma_x^2 = \frac{1}{I} \sum_{i=1}^{I} (x_i - \mu_x)^2$$

$$\sigma_y^2 = \frac{1}{I} \sum_{i=1}^{I} (y_i - \mu_y)^2$$

Accordingly, based on equation (5), the correlation coefficient $\rho_{xy}[I_J]$ of the solar radiation intensity x and the generated power y in the J-th local segment $I_J$ is obtained according to the following equation (6), using the average $\mu_x[I_J]$ of the solar radiation intensity x, the average $\mu_y[I_J]$ of the generated power y, the variance (standard deviation) $\sigma_x^2[I_J]$ of the solar radiation intensity x, and the variance (standard deviation) $\sigma_y^2[I_J]$ of the generated power y.
[Equation 6]

$$\rho_{xy}[I_j] = \frac{\sum_{i=I_{j-1}+1}^{I_j} (x_i - \mu_x[I_j])(y_i - \mu_y[I_j])}{\sigma_x[I_j]\,\sigma_y[I_j]}$$

$$\mu_x[I_j] = \frac{1}{\Delta I} \sum_{i=I_{j-1}+1}^{I_j} x_i$$

$$\mu_y[I_j] = \frac{1}{\Delta I} \sum_{i=I_{j-1}+1}^{I_j} y_i \qquad \cdots (6)$$

$$\sigma_x^2[I_j] = \frac{1}{\Delta I} \sum_{i=I_{j-1}}^{I_j} (x_i - \mu_x)^2$$

$$\sigma_y^2[I_j] = \frac{1}{\Delta I} \sum_{i=I_{j-1}}^{I_j} (y_i - \mu_y)^2$$

Thus, the solar radiation variation determination unit 53 can obtained the correlation coefficient $\rho_{xy}[I_J]$ of the solar radiation intensity x and the generated power y in the J-th local segment $I_J$.

Also, if the correlation coefficients for each local segment are larger than the solar radiation variation determination threshold stored in the solar radiation variation determination threshold storage unit 54, the solar radiation variation determination unit 53 outputs the determination result (OK) for determining that the degree of similarity between the generated power data and the solar radiation intensity data in that local segment is high. On the other hand, if the correlation coefficient for each local segment is less than or equal to the solar radiation variation determination threshold stored in the solar radiation variation determination threshold storage unit 54, the solar radiation variation determination unit 53 outputs the determination result (NOT OK) for determining that the degree of similarity between the generated power data and the solar radiation intensity data in that local segment is low.

For example, with the generated power data and solar radiation intensity data shown in FIG. 11A, letting the solar radiation variation determination threshold be 0.7, the determination results in all of the local areas are OK. That is to say, a result such that the correlation coefficients of the local segments are high throughout the day is obtained.

On the other hand, with the generated power data and solar radiation intensity data shown in FIG. 11B, letting the solar radiation variation determination threshold be 0.7, the determination results in the local segment $I_1$ and the local segment $I_2$ are NOT OK, and the determination results in the local segment $I_3$ and the local segment $I_4$ are OK. In other words, a result such that local segments whose correlation coefficients are low exist in the day is obtained.

Accordingly, by not using the generated power data and the solar radiation intensity data of local segments whose determination results are NOT OK when constructing the generated power estimation model, the accuracy of the generated power estimation model can be improved.

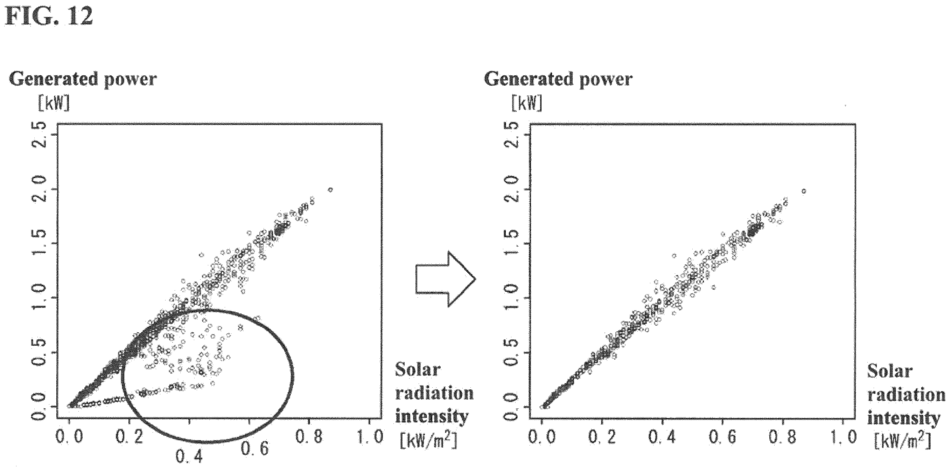

That is to say, if all of the accumulated generated power data and solar radiation intensity data is used, noise will appear as shown on the left side of FIG. 12. However, by not using the generated power data and solar radiation intensity data of local segments whose determination results are NOT OK, the influence of intra-day variation in solar radiation, which has less correlation, can be eliminated as shown on the right side of FIG. 12. Accordingly, erroneous detection can be prevented.

Also, a generated power estimation model by means of a linear regression is obtained using the following equation (7).

[Equation 7]

$$y_i = \alpha_j x_i + \beta_j$$

$$\alpha_j' = {}^*\rho_{xy} \frac{{}^*\sigma_y}{{}^*\sigma_x} \qquad \cdots (7)$$

$$\beta_j' = {}^*\mu_y - \alpha_j' \, {}^*\mu_x$$

Here, in equation (7), a regression coefficient $\alpha_J'$ and a regression coefficient $\beta_J'$ are calculated using all of the past data resulting from removing the noise.

Also, solar radiation variation determination and generated power estimation are performed using the correlation coefficient $\rho_{xy}$ [$I_J$] of the local segment $I_J$.

For example, if the correlation coefficient $\rho_{xy}$ [$I_J$] of the local segment $I_J$ is larger than the solar radiation variation determination threshold $\rho_{th}$ ($\rho_{xy}$ [$I_J$] > $\rho_{th}$), the model update unit 63 updates the regression coefficient $\alpha_J'$ and the regression coefficient $\beta_J'$ and newly constructs a generated power estimation model based on the above-described equation (7).

On the other hand, if the correlation coefficient $\rho_{xy}$ [$I_J$] of the local segment $I_J$ is not larger than the solar radiation variation determination threshold $\rho_{th}$ ($\rho_{xy}$ [$I_J$] $\leq$ $\rho_{th}$), the model update unit 63 does not update the regression coefficient $\alpha_J'$ and the regression coefficient $\beta_J'$. For example, in such a case, the model update unit 63 may input an actual value of the generated power.

Also, according to the sampling rate $S_R$ for when measuring the solar radiation intensity $x_i$ and the generated power yi, the generated power estimation unit 56 can use the following equation (8) to obtain the solar radiation amount X from the solar radiation intensity $x_i$, obtain the generated power amount Y from the generated power $y_i$, and obtain the expected generated power amount Y' from the generated power $y_i'$.

[Equation 8]

$$X = \sum_{i=1}^{I} x_i \times \frac{S_R}{3600}$$

$$Y = \sum_{i=1}^{I} y_i \times \frac{S_R}{3600} \qquad \cdots (8)$$

$$Y' = \sum_{i=1}^{I} y_i' \times \frac{S_R}{3600}$$

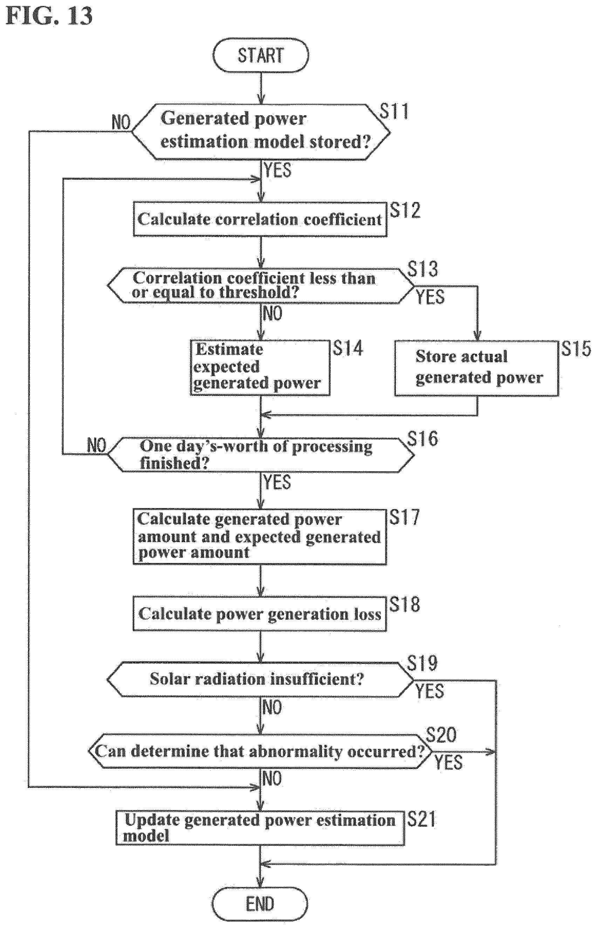

Next, FIG. 13 is a flowchart for describing the processing performed by the abnormality determination processing device 24.

For example, when the generated power data and the solar radiation intensity data are newly stored in the generated power storage unit 51 and the solar radiation intensity storage unit 52, the processing is started. First, in step S11, the solar radiation variation determination unit 53 determines whether or not the generated power estimation model already exists and is stored in the generated power estimation model storage unit 64. Also, if the solar radiation variation determination unit 53 determines that the generated power estimation model is stored in the generated power estimation model storage unit 64, the processing moves to step S12.

In step S12, the solar radiation variation determination unit 53 uses the above-described equation (6) to calculate the correlation coefficient for the solar radiation intensity and the generated power for each local segment in the newly-stored generated power data and solar radiation intensity data.

In step S13, the solar radiation variation determination unit 53 determines whether or not the correlation coefficient calculated in step S12 is less than or equal to the solar radiation variation determination threshold stored in the solar radiation variation determination threshold storage unit 54.

In step S13, if the solar radiation variation determination unit 53 determines that the correlation coefficient is not less than or equal to the solar radiation variation determination threshold (the correlation coefficient is greater than the solar radiation variation determination threshold), the processing moves to step S14.

In step S14, the solar radiation variation determination unit 53 stores a determination result (OK) indicating that the degree of similarity between the generated power data and the solar radiation intensity data is high in the solar radiation variation determination result storage unit 55. Accordingly, the generated power estimation unit 56 calculates the solar radiation amount by integrating the solar radiation intensity data, and inputs it into the generated power estimation model stored in the generated power estimation model storage unit 64 so as to estimate the expected generated power amount, and stores the estimated expected generated power amount in the expected generated power amount storage unit 57.

On the other hand, if the solar radiation variation determination unit 53 determines in step S13 that the correlation coefficient is less than or equal to the solar radiation variation determination threshold, the processing moves to step S15.

In step S15, the solar radiation variation determination unit 53 stores a determination result (NOT OK) indicating that the degree of similarity between the generated power data and the solar radiation intensity data is low in the solar radiation variation determination result storage unit 55. Accordingly, the generated power estimation unit 56 determines that the expected generated power amount cannot be estimated and, for example, stores the actual generated power in the expected generated power amount storage unit 57.

After the processing of step S14 or S15, the processing moves to step S16, and the solar radiation variation determination unit 53 determines whether or not the processing for calculating the correlation coefficients has ended for one day's-worth of generated power data and solar radiation intensity data.

If the solar radiation variation determination unit 53 determines in step S16 that the processing for calculating one day's-worth of correlation coefficients has not ended, the processing returns to step S12, and similar processing is repeated thereafter.

On the other hand, if the solar radiation variation determination unit 53 determines in step S16 that processing for calculating one day's-worth of correlation coefficients has ended, the processing moves to step S17.

In step S17, the device abnormality determination unit 58 reads outs the generated power data from the generated power storage unit 51 and calculates a generated power amount for one day. Also, the device abnormality determination unit 58 reads out the expected generated power amount stored in the expected generated power amount storage unit 57 and calculates an expected generated power amount for the day.

In step S18, the device abnormality determination unit 58 calculates the power generation loss by obtaining the difference between the generated power amount and expected generated power amount calculated in step S17.

In step S19, the device abnormality determination unit 58 determines whether or not solar radiation is insufficient by reading out the solar radiation intensity data from the solar radiation intensity storage unit 52, calculating the solar radiation amount, and comparing the solar radiation amount with the solar radiation insufficiency determination threshold.

If it is determined in step S19 that the solar radiation is not insufficient, the processing moves to step S20, and the device abnormality determination unit 58 determines whether or not it can be determined that an abnormality has occurred by comparing the power generation loss calculated in step S18 with the device abnormality determination threshold stored in the device abnormality determination threshold storage unit 60. For example, if the power generation loss is greater than or equal to the device abnormality determination threshold, it is determined that it can be determined that an abnormality has occurred, and if the power generation loss is not greater than or equal to the device abnormality determination threshold, it is determined that it cannot be determined that an abnormality has occurred.

If it is determined in step S20 that it cannot be determined that an abnormality has occurred, the processing moves to step S21.

In step S21, the model update unit 63 updates statistical information by adding the solar radiation intensity and generated power for which it has been determined that no abnormality has occurred to the statistical information (correlative relationship between the solar radiation intensity and generated power shown in FIG. 4) used to construct the current generated power estimation model stored in the generated power estimation model storage unit 64. Also, the model update unit 63 constructs a new generated power estimation model using the updated statistical information.

Note that in step S11, the processing moves to step S21 also in the case where it is determined that the generated power estimation model is not stored in the generated power estimation model storage unit 64. In this case, the model update unit 63 constructs the generated power estimation model using the newly-stored generated power data and solar radiation intensity data and stores it in the generated power estimation model storage unit 64.

On the other hand, if it is determined in step S19 that the solar radiation is insufficient, if it is determined in step S20 that it can be determined that an abnormality has occurred, or after the processing of step S21 ends, the processing is ended.

As described above, with the abnormality determination processing device 24, if the degree of similarity between the generated power data and the solar radiation intensity data is low due to variation in the solar radiation, the generated power data and the solar radiation intensity data are prevented from being used in the construction of the generated power estimation model. Accordingly, since the generated power estimation model can be constructed based on only generated power data and solar radiation intensity data whose degree of similarity is high, a generated power estimation model that enables more accurate determination of the occurrence of an abnormality can be constructed.

Furthermore, since the expected generated power amount can be estimated using a generated power estimation model with a high accuracy, the power generation loss can be calculated accurately, and the occurrence of an abnormality can be detected more reliably. Accordingly, it is possible to avoid cases in which the occurrence of an abnormality is overlooked, or in which it is determined that an abnormality has occurred even though an abnormality has not occurred, and the monitoring and maintenance of the solar power generation system 11 can be performed more appropriately.

Also, since the abnormality determination processing device 24 can determine the occurrence of an abnormality by acquiring data through communication with the power control device 25, the monitoring and maintenance of the solar power generation system 11 can be performed from a remote location.

Note that the power control device 25 need not be configured to include the abnormality determination processing device 24, and the determination of an abnormality in the solar power generation system 11 can be determined by the power control unit 25 alone.

Also, for example, the data recording unit 45, which acquires the solar radiation intensity data in which the change over time in the solar radiation intensity is recorded by reading out the solar radiation intensity measured by the solar radiation meter 23 and acquires the generated power data in which the change over time in the generated power is recorded by reading out the generated power measured by the power measurement unit 43, may be constituted by a single apparatus. In this cause, the data recording unit 45 can be configured to accumulate the solar radiation intensity data and generated power data and to include the function of the abnormality determination processing device 24. Accordingly, the occurrence of an abnormality in the solar power generation system 11 can be determined by the data recording unit 45 alone.

Note that in the present embodiment, processing for measuring the solar radiation intensity and generated power, estimating the expected generated power amount, and determining the occurrence of an abnormality is performed for the solar power generation module 22 as a whole, but this processing may be performed in units of solar cell panels, strings, or arrays constituting the solar power generation module 22. For example, by measuring the solar radiation intensity and generated power and estimating the expected generated power amount in units of strings, the occurrence of an abnormality can be determined for each string.

Also, with the solar power generation system 21, a configuration is used in which the solar radiation amount (i.e., the amount of energy in the sunlight) is calculated based on the solar radiation intensity measured by the solar radiation meter 23, and an illuminometer that measures the illuminance of sunlight, for example, is used to calculate the amount of energy in the sunlight emitted to the solar power generation module 22. Alternatively, a solar cell panel for measurement may be used to calculate the amount of energy in the sunlight emitted to the solar power generation module 22 based on the amount of power generated by the solar cell panel.

Furthermore, for example, data on the solar radiation amount observed by multiple weather observatories that are included in a regional weather observation system may be acquired without using the solar radiation meter 15 disposed near the solar power generation module 22. Also, these pieces of data on the solar radiation amount may be used to estimate the solar radiation amount at the location at which the solar power generation module 22 is disposed based on the positional information (latitudes and longitudes) of the locations at which the weather observatories and solar power generation module 22 are disposed. Note that in this case, reliability can be further improved by estimating the solar radiation amount using the data on the solar radiation amount of a weather observatory disposed in the vicinity of the solar power generation module 22.

Note that the processes described with reference to the flowchart above need not necessarily be processed in a time series in the order they are presented in the flowchart, and the processes also include processing executed in parallel or separately (e.g., parallel processing or processing by means of an object). Also, the program may be processed by one CPU or it may be processed in a decentralized manner by a plurality of CPUs.

Also, the above-described series of processes (information processing methods) can be executed using hardware and can be executed using software. In the case of executing the series of processes using software, a program constituting the software is installed in, for example, a computer incorporated in dedicated hardware, a general-use personal computer capable of executing various functions by installing various programs, or the like, from a program storage medium on which the program is recorded.

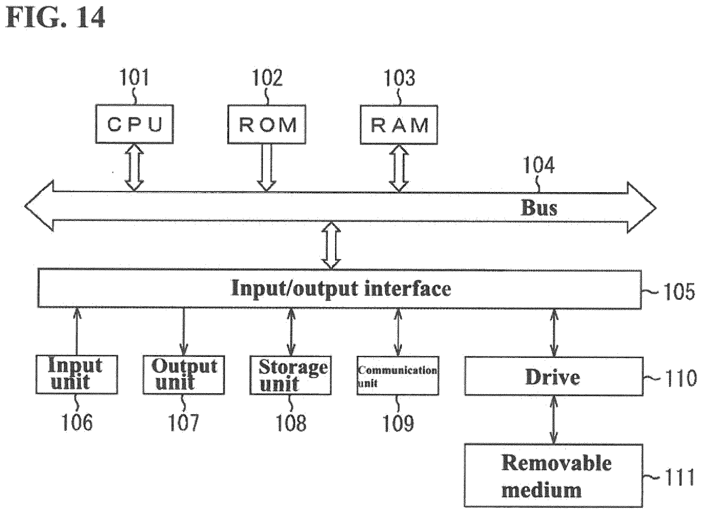

FIG. 14 is a block diagram showing an example of a configuration of the hardware of the computer that executes the above-described series of processes using the program.

In the computer, a CPU (central processing unit) 101, a ROM (read only memory) 102, and a RAM (random access memory) 103 are connected to each other by a bus 104.

An input/output interface 105 is furthermore connected to the bus 104. An input unit 106 constituted by a keyboard, mouse, microphone, and the like, an output unit 107 constituted by a display, speaker, and the like, a storage unit 108 constituted by a hard disk, non-volatile memory, or the like, a communication unit 109 constituted by a network interface or the like, and a drive 110 that drives a removable medium 111 such as a magnetic disk, an optical disk, a magneto-optical disk, a semiconductor memory, or the like are connected to the input/output interface 105.

With a computer configured in this manner, the CPU 101 executes a program stored in the storage unit 108 by loading it in the RAM 103 via the input/output interface 105 and the bus 104, and thus the above-described series of processes is performed.

The program executed by the computer (CPU 101) is stored in the removable medium 111, which is a package medium constituted by a magnetic disk (includes flexible disks), an optical disk (CD-ROM (compact disc read only memory), DVD (digital versatile disc), etc.), a magneto-optical disk, a semiconductor memory, or the like, or is provided via a wired or wireless transfer medium, such as a local area network, the Internet, or digital satellite broadcasting.

Also, the program can be installed in the storage unit 108 via the input/output interface 105 by mounting the removable medium 111 in the drive 110. Also, the program can be received by the communication unit 109 via a wired or wireless transfer medium, and can be installed in the storage unit 108. Also, the program can be installed in advance in the ROM 102 or the storage unit 108. Also, in the specification, "system" refers to an entire device constituted by multiple devices.

INDEX TO THE REFERENCE NUMERALS

11 ... solar power generation system, 12 ... solar power generation module, 13 ... power measurement unit, 14 ... inverter, 15 ... solar radiation meter, 16 ... abnormality determination unit, 21 ... solar power generation system, 22 ... solar power generation module, 23 ... solar radiation meter, 24 ... abnormality determination processing device, 25 ... power control device, 31 ... power system, 32 ... AC load, 33-1, 33-2 ... DC load, 41 ... AC/DC conversion unit, 42 ... PV DC/DC conversion unit, 43 ... power measurement unit, 44 ... load DC/DC conversion unit, 45 ... data storage unit, 46 ... communication unit, 47 ... DC bus, 51 ... generated power storage unit, 52 ... solar radiation intensity storage unit, 53 ... solar radiation variation determination unit, 54 ... solar radiation variation determination threshold storage unit, 55 ... solar radiation variation determination result storage unit, 56 ... generated power estimation unit, 57 ... expected generated power amount storage unit, 58 ... device abnormality determination unit, 59 ... solar radiation insufficiency determination threshold storage unit, 60 ... device abnormality determination threshold storage unit, 61 ... power generation loss storage unit, 62 ... abnormality determination result storage unit, 63 ... model update unit, 64 ... generated power estimation model storage unit

**Claims**

1. A solar power generation system (11; 21) comprising:

   a solar power generation unit (12; 22) configured to generate power by receiving sunlight; and
   an abnormality determination processing device (24), comprising:

   a model construction unit configured to construct a generated power estimation model based on a correlative relationship for each day between a generated power amount generated by the solar power generation unit (12; 22) that generates power by receiving sunlight, and an energy amount of sunlight emitted to the solar power generation unit (12; 22), the generated power estimation model being used for estimating an expected generated power amount that is expected to be generated by the solar power generation unit (12; 22);
   an estimation unit (56) configured to estimate the expected generated power amount based on the generated power estimation model; and
   an abnormality determination unit (58) configured to determine whether or not an abnormality has occurred by comparing the expected generated power amount and a generated power amount that is actually generated by the solar power generation unit (12; 22);

   **characterized by**
   a solar radiation variation determination unit (53) configured to,

   - for each local segment ($I_1$, ..., $I_N$) obtained by dividing a predetermined period of a day in which power is generated by a predetermined number (N), calculate a correlation coefficient ($\rho_{xy}$) between the generated power (y) generated by the solar power generation unit (12; 22) and the solar radiation intensity (x) irradiated on the solar power generation unit (12; 22), and
   - to determine whether or not a degree of similarity is high for each of the local segments (I1, ..., IN) depending on whether the correlation coefficient ($\rho xy$) exceeds a predetermined solar radiation variation determination threshold,

   wherein the estimation unit (56) estimates the expected generated power amount only in such local segments ($I_1$, ..., $I_N$) for which it is determined by the solar radiation variation determination unit (53) that the degree of similarity is high.

2. The solar power generation system according to claim 1, wherein
   the model construction unit constructs the generated power estimation model using only the generated power and the energy amount in the local segments ($I_1$, ..., $I_N$) for which it is determined by the solar radiation variation determination unit (53) that the degree of similarity is high.

3. The solar power generation system according to claim 1, wherein
   if the energy amount for one day obtained from the energy amount is less than or equal to a predetermined threshold, the abnormality determination unit (24) avoids determining whether or not an abnormality has occurred.

4. An abnormality determination processing method comprising the steps of:

constructing a generated power estimation model based on a correlative relationship for each day between a generated power amount generated by a solar power generation unit (12; 22) that generated power by receiving sunlight, and an energy amount of sunlight emitted to the solar power generation unit (12; 22), the generated power estimation model being used for estimating an expected generated power amount that is expected to be generated by the solar power generation unit (12; 22);
estimating the expected generated power amount based on the generated power estimation model; and determining whether or not an abnormality has occurred by comparing the expected generated power amount and a generated power amount that is actually generated by the solar power generation unit (12; 22); **characterized by** the following steps:

- calculating, for each local segment ($I_1$, ..., $I_N$) obtained by dividing a predetermined period of a day in which power is generated by a predetermined number (N), a correlation coefficient ($\rho_{xy}$) between the generated power (y) generated by the solar power generation unit (12; 22) and the solar radiation intensity (x) irradiated on the solar power generation unit (12; 22), and
- determining whether or not a degree of similarity is high for each of the local segments ($I_1$, ..., $I_N$) depending on whether the correlation coefficient ($\rho_{xy}$) exceeds a predetermined solar radiation variation determination threshold,
wherein the estimation unit (56) estimates the expected generated power amount only in such local segments ($I_1$, ..., $I_N$) for which it is determined by the solar radiation variation determination unit (53) that the degree of similarity is high.

5. A program, when run on a computer, causing said computer to execute the steps of the abnormality determination processing method according to claim 4.


**Patentansprüche**

1. Solarenergieerzeugungssystem (11; 21), umfassend:

eine Solarenergieerzeugungseinheit (12; 22), welche eingerichtet ist, durch Empfangen von Sonnenlicht Energie zu erzeugen; und
eine Abnormalitätsbestimmungsverarbeitungseinrichtung (24), umfassend:

eine Modellkonstruktionseinheit, weiche eingerichtet ist, ein Modell zur Schätzung erzeugter Energie zu konstruieren, weiches auf einer korrelativen Beziehung für jeden Tag zwischen einer erzeugten Energiemenge, welche durch die Solarenergieerzeugungseinheit (12; 22) erzeugt wird, die Energie durch Empfangen von Sonnenlicht erzeugt, und einer Energiemenge des zu der Solarenergieerzeugungseinheit (12; 22) abgestrahlten Sonnenlichts basiert, wobei das Modell zur Schätzung erzeugter Energie zum Schätzen einer erwarteten erzeugten Energiemenge, die erwartet wird, von der Solarenergieerzeugungseinheit (12; 22) erzeugt zu werden, verwendet wird;
eine Schätzungseinheit (56), welche eingerichtet ist, die erwartete erzeugte Energiemenge, die auf dem Modell zur Schätzung erzeugter Energie basiert, zu schätzen; und
eine Abnormalitätsbestimmungseinheit (58), welche eingerichtet ist, zu bestimmen, ob eine Abnormalität aufgetreten ist oder nicht, durch Vergleich der erwarteten erzeugten Energiemenge und einer erzeugten Energiemenge, die tatsächlich durch die Solarenergieerzeugungseinheit (12; 22) erzeugt wird;

**gekennzeichnet durch**
eine Solarstrahlungsveränderungsbestimmungseinheit (53), die eingerichtet ist,

- für jedes lokale Segment ($I_1$, ..., $I_N$), welches durch Division einer vorbestimmten Zeitspanne eines Tages, in der Energie erzeugt wird, durch eine vorbestimmte Zahl (N) erhalten wird, einen Korrelationskoeffizienten ($\rho_{xy}$) zwischen der erzeugten Energie (y), welche durch die Solarenergieerzeugungseinheit (12; 22) erzeugt wird, und der Solarstrahlungsintensität (x), welche auf die Solarenergieerzeugungseinheit (12; 22) gestrahlt wird, zu berechnen, und

- zu bestimmen, ob für jedes der lokalen Segmente (I1, ..., IN) ein Grad der Ähnlichkeit hoch ist oder nicht, in Abhängigkeit davon, ob der Korrelationskoeffizient ($\rho$xy) einen vorbestimmten Solarstrahlungsveränderungsbestimmungsschwellenwert überschreitet,

wobei die Schätzungseinheit (56) die erwartete erzeugte Energiemenge nur in solchen lokalen Segmenten ($I_1$, ..., $I_N$) schätzt, für die von der Solarstrahlungsveränderungsbestimmungseinheit (53) bestimmt wird, dass der Grad der Ähnlichkeit hoch ist.

2. Solarenergieerzeugungssystem gemäß Anspruch 1, wobei
die Modellkonstruktionseinheit das Modell zur Schätzung erzeugter Energie nur unter Verwendung der erzeugten Energie und der Energiemenge in den lokalen Segmenten ($I_1$, ..., $I_N$), für die von der Solarstrahlungsveränderungsbestimmungseinheit (53) bestimmt wird, dass der Grad der Ähnlichkeit hoch ist, konstruiert.

3. Solarenergieerzeugungssystem gemäß Anspruch 1, wobei,
wenn die Energiemenge für einen Tag, welche von der Energiemenge erhalten wird, kleiner oder gleich einem vorbestimmten Schwellenwert ist, die Abnormalitätsbestimmungseinheit (24) das Bestimmen, ob eine Abnormalität aufgetreten ist oder nicht, vermeidet.

4. Abnormalitätsbestimmungsverarbeitungsverfahren, umfassend die folgenden Schritte:

Konstruieren eines Modells zur Schätzung erzeugter Energie, welches auf einer korrelativen Beziehung für jeden Tag zwischen einer erzeugten Energiemenge, welche durch die Solarenergieerzeugungseinheit (12; 22) erzeugt wird, die Energie durch Empfangen von Sonnenlicht erzeugt, und einer Energiemenge des zu der Solarenergieerzeugungseinheit (12; 22) abgestrahlten Sonnenlichts basiert, wobei das Modell zur Schätzung erzeugter Energie zum Schätzen einer erwarteten erzeugten Energiemenge, die erwartet wird, von der Solarenergieerzeugungseinheit (12; 22) erzeugt zu werden, verwendet wird;
Schätzen der erwarteten erzeugten Energiemenge, welche auf dem Modell zur Schätzung erzeugter Energie basiert; und
Bestimmen, ob eine Abnormalität aufgetreten ist oder nicht, durch Vergleich der erwarteten erzeugten Energiemenge und einer erzeugten Energiemenge, die tatsächlich durch die Solarenergieerzeugungseinheit (12; 22) erzeugt wird;

**gekennzeichnet durch** die folgenden Schritte:

- Berechnen, für jedes lokale Segment ($I_1$, ..., $I_N$), welches durch Division einer vorbestimmten Zeitspanne eines Tages, in der Energie erzeugt wird, durch eine vorbestimmte Zahl (N) erhalten wird, eines Korrelationskoeffizienten ($\rho_{xy}$) zwischen der erzeugten Energie (y), welche durch die Solarenergieerzeugungseinheit (12; 22) erzeugt wird, und der Solarstrahlungsintensität (x), welche auf die Solarenergieerzeugungseinheit (12; 22) gestrahlt wird, und
- Bestimmen, ob für jedes der lokalen Segmente (I1, ..., IN) ein Grad der Ähnlichkeit hoch ist oder nicht, in Abhängigkeit davon, ob der Korrelationskoeffizient ($\rho$xy) einen vorbestimmten Solarstrahlungsveränderungsbestimmungsschwellenwert überschreitet,

wobei die Schätzungseinheit (56) die erwartete erzeugte Energiemenge nur in solchen lokalen Segmenten ($I_1$, ..., $I_N$) schätzt, für die von der Solarstrahlungsveränderungsbestimmungseinheit (53) bestimmt wird, dass der Grad der Ähnlichkeit hoch ist.

5. Programm, wenn es auf einem Computer abläuft, bewirkt, dass der Computer die Schritte des Abnormalitätsbestimmungsverarbeitungsverfahrens gemäß Anspruch 4 ausführt.

**Revendications**

1. Système de génération d'énergie solaire (11 ; 21) comprenant :

une unité de génération d'énergie solaire (12 ; 22) configurée pour générer de l'énergie en recevant la lumière du soleil ; et
un dispositif de traitement de détermination d'anomalie (24), comprenant :

une unité de construction de modèle configurée pour construire un modèle d'estimation d'énergie générée sur la base d'une relation de corrélation pour chaque jour entre une quantité d'énergie générée qui est générée par l'unité de génération d'énergie solaire (12 ; 22) qui génère de l'énergie en recevant la lumière du soleil, et une quantité d'énergie de lumière du soleil émise vers l'unité de génération d'énergie solaire (12 ; 22), le modèle d'estimation d'énergie générée étant utilisé pour estimer une quantité d'énergie générée attendue que l'on attend à voir générée par l'unité de génération d'énergie solaire (12 ; 22) ;

une unité d'estimation (56) configurée pour estimer la quantité d'énergie générée attendue sur la base du modèle d'estimation d'énergie générée ; et

une unité de détermination d'anomalie (58) configurée pour déterminer si une anomalie s'est produite ou non en comparant la quantité d'énergie générée attendue et une quantité d'énergie générée qui est réellement générée par l'unité de génération d'énergie solaire (12 ; 22) ;

**caractérisé par**
une unité de détermination de variation de rayonnement solaire (53) configurée pour,

- pour chaque segment local ($I_1$, ..., $I_N$) obtenu en divisant une période prédéterminée d'un jour dans laquelle l'énergie est générée par un nombre prédéterminé (N), calculer un coefficient de corrélation ($\rho_{xy}$) entre l'énergie générée (y) générée par l'unité de génération d'énergie solaire (12 ; 22) et l'intensité de rayonnement solaire (x) irradiée sur l'unité de génération d'énergie solaire (12 ; 22), et
- déterminer si un degré de similitude est élevé ou non pour chacun des segments locaux ($I_1$, ..., $I_N$) selon que le coefficient de corrélation ($\rho_{xy}$) dépasse un seuil de détermination de variation de rayonnement solaire prédéterminé,

dans lequel l'unité d'estimation (56) estime la quantité d'énergie générée attendue uniquement dans les segments locaux ($I_1$, .., $I_N$) pour lesquels on détermine par l'unité de détermination de variation de rayonnement solaire (53) que le degré de similitude est élevé.

2. Système de génération d'énergie solaire selon la revendication 1, dans lequel
l'unité de construction de modèle construit le modèle d'estimation d'énergie générée en n'utilisant que l'énergie générée et la quantité d'énergie dans les segments locaux ($I_1$, ..., $I_N$) pour lesquels on détermine par l'unité de détermination de variation de rayonnement solaire (53) que le degré de similitude est élevé.

3. Système de génération d'énergie solaire selon la revendication 1, dans lequel
si la quantité d'énergie pour un jour obtenue à partir de la quantité d'énergie est inférieure ou égale à un seuil prédéterminé, l'unité de détermination d'anomalie (24) évite de déterminer si une anomalie s'est produite ou non.

4. Procédé de traitement de détermination d'anomalie comprenant les étapes consistant à :

construire un modèle d'estimation d'énergie générée sur la base d'une relation de corrélation pour chaque jour entre une quantité d'énergie générée qui est générée par une unité de génération d'énergie solaire (12 ; 22) qui a généré de l'énergie en recevant la lumière du soleil, et une quantité d'énergie de lumière du soleil émise vers l'unité de génération d'énergie solaire (12 ; 22), le modèle d'estimation d'énergie générée étant utilisé pour estimer une quantité d'énergie générée attendue que l'on attend à voir générée par l'unité de génération d'énergie solaire (12 ; 22) ;

estimer la quantité d'énergie générée attendue sur la base du modèle d'estimation d'énergie générée ; et déterminer si une anomalie s'est produite ou non en comparant la quantité d'énergie générée attendue et une quantité d'énergie générée qui est réellement générée par l'unité de génération d'énergie solaire (12 ; 22) ;
**caractérisé par** les étapes suivantes :

- le calcul, pour chaque segment local ($I_1$, ..., $I_n$) obtenu en divisant une période prédéterminée d'un jour dans laquelle l'énergie est générée par un nombre prédéterminé (N), d'un coefficient de corrélation ($\rho_{xy}$) entre l'énergie générée (y) générée par l'unité de génération d'énergie solaire (12 ; 22) et l'intensité de rayonnement solaire (x) irradiée sur l'unité de génération d'énergie solaire (12 ; 22), et
- le fait de déterminer si un degré de similitude est élevé ou non pour chacun des segments locaux ($I_1$, ..., $I_N$) selon que le coefficient de corrélation ($\rho_{xy}$) dépasse un seuil de détermination de variation de rayonnement solaire prédéterminé,

dans lequel l'unité d'estimation (56) estime la quantité d'énergie générée attendue uniquement dans les seg-

ments locaux ($I_1$, ..., $I_N$) pour lesquels on détermine par l'unité de détermination de variation de rayonnement solaire (53) que le degré de similitude est élevé.

5. Programme, lorsqu'il est exécuté sur un ordinateur, amenant ledit ordinateur à exécuter les étapes du procédé de traitement de détermination d'anomalie selon la revendication 4.

# FIG. 1

Input: solar radiation

Abnormality determination unit — 16

15

11

13

14

12

To system or load

Output: power

## FIG. 2

Solar radiation intensity [kW/m²]

1st day | 2nd day | 3rd day | 4th day | 5th day | 6th day | 7th day

A

Generated power [kW]

1st day | 2nd day | 3rd day | 4th day | 5th day | 6th day | 7th day

B

## FIG. 3

A

B

## FIG. 4

## FIG. 5

**Solar radiation intensity [kW/m²]**

A

**Expected generated power [kW]**

B

**Generated power [kW]**

C

# FIG. 6

A

B

C

# FIG. 7

Legend:
- ─·─·─ DC power
- ──── AC power
- - - - - Solar radiation intensity

Generated power [kW]   Solar radiation intensity [kW/m²]

EP 2 996 158 B1

**FIG. 8**

Generated power [kW] vs Solar radiation intensity [kW/m²]

# FIG. 9

EP 2 996 158 B1

**FIG. 10**

## FIG. 11

A

B

EP 2 996 158 B1

**FIG. 12**

## FIG. 13

START

S11 — Generated power estimation model stored?
NO →
YES ↓

S12 — Calculate correlation coefficient

S13 — Correlation coefficient less than or equal to threshold?
YES →
NO ↓

S14 — Estimate expected generated power

S15 — Store actual generated power

S16 — One day's-worth of processing finished?
NO →
YES ↓

S17 — Calculate generated power amount and expected generated power amount

S18 — Calculate power generation loss

S19 — Solar radiation insufficient?
YES →
NO ↓

S20 — Can determine that abnormality occurred?
YES →
NO ↓

S21 — Update generated power estimation model

END

# FIG. 14

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2011181614 A
- US 2012323507 A1
- US 2011307199 A1